(19) Europäisches Patentamt
European Patent Office
Office européen des brevets

(11) EP 4 773 758 A1

(12) **EUROPEAN PATENT APPLICATION**
published in accordance with Art. 153(4) EPC

(43) Date of publication:
**08.07.2026 Bulletin 2026/28**

(21) Application number: **24859501.9**

(22) Date of filing: **19.08.2024**

(51) International Patent Classification (IPC):
***H10F 30/20*** *(2025.01)*

(52) Cooperative Patent Classification (CPC):
**H10K 39/32**

(86) International application number:
**PCT/JP2024/029229**

(87) International publication number:
**WO 2025/047466 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.08.2023 JP 2023139478**

(71) Applicant: **FUJIFILM Corporation**
**Tokyo 106-8620 (JP)**

(72) Inventors:
- **TAKATA Masahiro**
**Haibara-gun, Shizuoka 421-0396 (JP)**
- **YAGISHITA Koichi**
**Haibara-gun, Shizuoka 421-0396 (JP)**
- **IWAMOTO Kazuya**
**Haibara-gun, Shizuoka 421-0396 (JP)**

(74) Representative: **HGF**
**HGF Limited**
**4th Floor, 1 City Square**
**Leeds LS1 2ES (GB)**

# (54) SEMICONDUCTOR FILM, LIGHT DETECTION ELEMENT, AND IMAGE SENSOR

(57) A semiconductor film including an aggregate of semiconductor quantum dots containing an In element and a Group 15 element, and a ligand coordinated to the semiconductor quantum dots, in which the Group 15 element includes an Sb element, the ligand includes a ligand containing a halogen element, the semiconductor film contains a nitrogen element, and a molar ratio of the nitrogen element to the In element is 0.01 to 0.10. A photodetector and an image sensor using the above-described semiconductor film.

## Description

## BACKGROUND OF THE INVENTION

1. Field of the Invention

The present invention relates to a semiconductor film containing semiconductor quantum dots. In addition, the present invention relates to a photodetector and an image sensor.

2. Description of the Related Art

In recent years, attention has been focused on photodetectors capable of detecting light in an infrared region in the fields such as smartphones, surveillance cameras, and in-vehicle cameras.
In the related art, a silicon photodiode in which a silicon wafer is used as a material of a photoelectric conversion layer has been used in a photodetector that is used for an image sensor or the like. However, a silicon photodiode has low sensitivity in the infrared region having a wavelength of 900 nm or more.
In addition, an InGaAs-based semiconductor material known as a near-infrared light-receiving element has a problem in that it requires extremely high-cost processes such as epitaxial growth or a step of bonding a substrate in order to realize a high quantum efficiency, and thus it has not been widely adopted.
In addition, in recent years, the use of the quantum dots for a photodetector has been also being studied.
Patent Literature 1 describes that PbS quantum dots are used for a photoelectric conversion layer of a photodetector.
Patent Literature 2 describes that InSb quantum dots are used for a photoelectric conversion layer of a photodetector.

2. Citation List

Patent Literature

Patent Literature 1 JP2020-150251A
Patent Literature 2 US11581501B

## SUMMARY OF THE INVENTION

In recent years, with the demand for performance improvement of an image sensor and the like, there is a demand for further improvement of various characteristics that are required for a photodetector used in the image sensor and the like. For example, one of the characteristics required for the photodetector is to have a high external quantum efficiency with respect to light having a target wavelength to be detected by the photodetector, and to have a small in-plane variation in the external quantum efficiency of the photodetector. In a case of increasing the external quantum efficiency of the photodetector, it is possible to increase the accuracy of detecting light in the photodetector. In addition, in a case where the in-plane variation in the external quantum efficiency of the photodetector is suppressed, the occurrence of noise and the like can be suppressed.
In addition, in the photodetector, it is preferable that the dark current is low. In a case where the dark current of the photodetector is reduced, a higher signal-to-noise ratio (SN ratio) can be obtained in the image sensor. The dark current is a current that flows in a case of not being irradiated with light.
As a result of carrying out studies on a photodetector in which semiconductor quantum dots containing an In element and a Group 15 element are used for a photoelectric conversion layer, the inventors of the present invention found that there is room for further improvement in these characteristics.
Therefore, an object of the present invention is to provide a semiconductor film, a photodetector, and an image sensor having a high external quantum efficiency, excellent in-plane uniformity of external quantum efficiency, and reduced dark current.
The present invention provides the following aspects.

<1> A semiconductor film comprising:

an aggregate of semiconductor quantum dots containing an In element and a Group 15 element; and

a ligand coordinated to the semiconductor quantum dots,
in which the Group 15 element includes an Sb element,
the ligand includes a ligand containing a halogen element,
the semiconductor film contains a nitrogen element, and
a molar ratio of the nitrogen element to the In element is 0.01 to 0.10.

<2> The semiconductor film according to claim 1, in which a molar ratio of the nitrogen element to the halogen element in the semiconductor film is 0.01 to 0.20.
<3> The semiconductor film according to claim 1, in which a molar ratio of the nitrogen element to the halogen element in the semiconductor film is 0.01 to 0.10.
<4> The semiconductor film according to any one of <1> to <3>, in which a molar ratio of the Sb element to the halogen element in the semiconductor film is 0.30 to 3.20.
<5> The semiconductor film according to any one of <1> to <4>, in which the ligand containing the halogen element is a ligand containing an iodine element.
<6> The semiconductor film according to any one of <1> to <5>, in which the ligand includes a ligand containing a sulfur element.
<7> The semiconductor film according to any one of <1> to <6>, in which the ligand containing the halogen element contains an In element.
<8> The semiconductor film according to any one of <1> to <7>, in which a band gap of the semiconductor quantum dots is 1.0 eV or less.
<9> A photodetector comprising the semiconductor film according to any one of <1> to <8>.
<10> An image sensor comprising the photodetector according to <9>.

According to the present invention, it is possible to provide a semiconductor film, a photodetector, and an image sensor having a high external quantum efficiency, excellent in-plane uniformity of external quantum efficiency, and reduced dark current.

## BRIEF DESCRIPTION OF THE DRAWINGS

FIG. 1 is a view illustrating an embodiment of a photodetector.

## DESCRIPTION OF THE PREFERRED EMBODIMENTS

Hereinafter, the details of the present invention will be described.
In the present specification, "to" is used to mean that numerical values described before and after "to" are included as a lower limit value and an upper limit value, respectively.
In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

<Semiconductor Film>

A semiconductor film according to the embodiment of the present invention includes an aggregate of semiconductor quantum dots containing an In element and a Group 15 element, and a ligand coordinated to the semiconductor quantum dots,

the Group 15 element includes an Sb element,
the ligand includes a ligand containing a halogen element,
the semiconductor film contains a nitrogen element, and
a molar ratio of the nitrogen element to the In element is 0.01 to 0.10.

The semiconductor film according to the embodiment of the present invention has a high external quantum efficiency, excellent in-plane uniformity of external quantum efficiency, and suppressed dark current. The details of the reason why such effects are obtained are unknown; however, it is presumed to be due to the following points.
It is presumed that, since the semiconductor film includes the ligand containing the halogen element and includes a predetermined amount of the nitrogen element, the distance between the semiconductor quantum dots is appropriately

maintained, and the surface defects of the semiconductor quantum dots can be reduced. Therefore, it is presumed that a semiconductor film having a high external quantum efficiency, excellent in-plane uniformity of external quantum efficiency, and suppressed dark current can be obtained.

The semiconductor film according to the embodiment of the present invention contains a nitrogen element, and examples of a component containing the nitrogen element contained in the semiconductor film according to the embodiment of the present invention include a ligand. It is preferable that the semiconductor film according to the embodiment of the present invention includes a ligand containing a nitrogen element, and a molar ratio of the nitrogen element to the In element is 0.01 to 0.10.

In the semiconductor film according to the embodiment of the present invention, the molar ratio of the nitrogen element to the In element (the number of moles of the nitrogen element/the number of moles of the In element) is preferably 0.01 to 0.07 and more preferably 0.01 to 0.03.

In the semiconductor film according to the embodiment of the present invention, the molar ratio of the nitrogen element to the halogen element (the number of moles of the nitrogen element/the number of moles of the halogen element) is preferably 0.01 to 0.20 and more preferably 0.01 to 0.10.

In the semiconductor film according to the embodiment of the present invention, the molar ratio of the Sb element to the halogen element (the number of moles of the Sb element/the number of moles of the halogen element) is preferably 0.30 to 3.20 and more preferably 0.50 to 3.00. The lower limit value of the molar ratio of the Sb element to the halogen element is preferably 0.60 or more and more preferably 1.00 or more. The upper limit value of the molar ratio of the Sb element to the halogen element is preferably 2.90 or less and more preferably 2.80 or less.

In the present specification, the "molar ratio of the nitrogen element to the In element", the "molar ratio of the nitrogen element to the halogen element", and the "molar ratio of the Sb element to the halogen element" for the semiconductor film can be calculated by measuring an elemental composition ratio of the semiconductor film by X-ray photoelectron spectroscopy.

The semiconductor film according to the embodiment of the present invention can be used for a photodetector or an image sensor. More specifically, the semiconductor film can be used for a photoelectric conversion layer of a photodetector or an image sensor. Therefore, the semiconductor film according to the embodiment of the present invention is preferably used as a photoelectric conversion layer of a photodetector or an image sensor.

Since the semiconductor film according to the embodiment of the present invention has excellent sensitivity to light having a wavelength in the infrared region, an image sensor in which the semiconductor film according to the embodiment of the present invention is used for a photoelectric conversion layer can be particularly preferably used as an infrared sensor. Therefore, the semiconductor film according to the embodiment of the present invention is preferably used as a photoelectric conversion layer of an infrared sensor.

The thickness of the semiconductor film is not particularly limited; however, it is preferably 10 to 1,000 nm from the viewpoint of obtaining high electrical conductivity. The lower limit of the thickness is preferably 20 nm or more and more preferably 30 nm or more. The upper limit of the thickness is preferably 600 nm or less, more preferably 550 nm or less, still more preferably 500 nm or less, and particularly preferably 450 nm or less.

(Aggregate of Semiconductor Quantum Dots Containing In Element and Group 15 Element)

The semiconductor film according to the embodiment of the present invention has an aggregate of semiconductor quantum dots containing an In element and a Group 15 element. The above-described Group 15 element in the semiconductor quantum dots contains an Sb element. It is noted that the aggregate of semiconductor quantum dots means a form in which a large number of semiconductor quantum dots (for example, 100 or more quantum dots per 1 $\mu m^2$) are arranged to be close to each other. In addition, in the present specification, the "semiconductor" means a substance having a specific resistance value of $10^{-2}$ $\Omega$cm or more and $10^8$ $\Omega$cm or less.

Examples of the semiconductor quantum dot material constituting the semiconductor quantum dots include a compound semiconductor containing an In element and a Group 15 element, and containing the Group 15 element and an Sb element. It is noted that the compound semiconductor is a semiconductor composed of two or more kinds of elements. Therefore, in the present specification, the "compound semiconductor containing an In element and a Group 15 element" is a compound semiconductor containing an In element and a Group 15 element as elements constituting the compound semiconductor.

The ratio of the number of the In elements to the number of the Group 15 elements in the semiconductor quantum dots is preferably 1.1 or more, more preferably 1.5 or more, and still more preferably 2.0 or more. The upper limit thereof is preferably 3.0 or less.

In the present specification, the value of the ratio of the number of the In elements to the number of the Group 15 elements in the semiconductor quantum dots can be calculated by measuring the elemental compositional ratio of the semiconductor quantum dots according to X-ray photoelectron spectroscopy. For example, it can be obtained by forming a film using a dispersion liquid of semiconductor quantum dots, subjecting this film to the measurement of the elemental

compositional ratio of the semiconductor quantum dots by X-ray photoelectron spectroscopy, and carrying out the calculation.

Examples of the method of setting the ratio of the number of the In elements to the number of the Group 15 elements to 1.1 or more for the semiconductor quantum dots include (1) a method of adjusting a mixing ratio of a compound A containing an In element to a compound B containing an Sb element in the synthesis of the semiconductor quantum dots (for example, setting a molar ratio of the In element to the Sb element to 2.1 or more), (2) a method of controlling an adding amount, injection rate, or the like of a reducing agent (a dioctyl ether of lithium triethylborohydride or the like) in the synthesis of the semiconductor quantum dots, and (3) a method of controlling a temperature profile such as a reaching temperature, a keeping time, and a temperature rising rate in a reaction.

The semiconductor quantum dots may further contain an element other than the In element and the Sb element. Examples of other elements include an Mg element, a Ca element, an Sr element, a Ba element, a Zn element, a Cd element, an Hg element, a B element, an Al element, a Ga element, an N element, a P element, an As element, and a Bi element, and a Zn element, an Al element, a Ga element, a P element, an As element, and a Bi element are preferable.

Specific examples of the semiconductor quantum dot include InSb and InSbAs.

The crystal structure of the semiconductor quantum dots is not particularly limited. Various crystal structures can be adopted depending on the kind of the element and the compositional ratio of the element constituting the semiconductor quantum dots. However, a crystal structure of a cubic crystal system or hexagonal system is preferable for the reason that it is easy to properly control a band gap as a semiconductor and it is easy to realize high crystallinity. In a case where the proportion of pure InSb is large in terms of the entire particles, a zinc blende structure is preferable for the reason that high crystallinity is easily realized. The crystal structure of the semiconductor quantum dots can be measured by an X-ray diffraction method or an electron diffraction method.

The band gap of the semiconductor quantum dots is preferably 1.2 eV or less and more preferably 1.0 eV or less. The lower limit value of the band gap of the semiconductor quantum dots is not particularly limited; however, it is preferably 0.3 eV or more and more preferably 0.5 eV or more.

The average particle diameter of the semiconductor quantum dots is preferably 3 to 20 nm. The upper limit value of the average particle diameter of the semiconductor quantum dots is preferably 15 nm or less and more preferably 10 nm or less. In a case where the average particle diameter of the semiconductor quantum dots is in the above-described range, it is possible for the photodetector to have a higher external quantum efficiency with respect to light having a wavelength in the infrared region. It is noted that in the present specification, the value of the average particle diameter of the semiconductor quantum dots is an average value of the particle diameters of ten semiconductor quantum dots which are randomly selected. A transmission electron microscope may be used for measuring the particle diameter of the semiconductor quantum dots.

(Ligand)

The semiconductor film according to the embodiment of the present invention contains a ligand that is coordinated to the semiconductor quantum dots. The ligand includes at least a ligand containing a halogen element. The ligand may further contain an organic ligand.

The ligand containing a halogen element is preferably an inorganic ligand containing a halogen element. The inorganic ligand containing a halogen element is easily coordinated to the semiconductor quantum dots and can suppress the generation of surface defects.

The ligand containing the halogen element preferably contains an In element. In particular, in a case where the semiconductor quantum dot has InSb as a mother crystal, and the ligand containing a halogen element contains an In element, it is considered that the ligand containing a halogen element is easily coordinated to an Sb site of the semiconductor quantum dot, and the occurrence of surface defects can be further suppressed.

Examples of the halogen element contained in the ligand containing a halogen element include a fluorine element, a chlorine element, a bromine element, and an iodine element, and an iodine element is preferable.

Specific examples of the ligand containing a halogen element include zinc iodide, zinc bromide, zinc chloride, indium iodide, indium bromide, indium chloride, cadmium iodide, cadmium bromide, cadmium chloride, gallium iodide, gallium bromide, and gallium chloride, and indium iodide is preferable.

It is noted that in the ligand containing a halogen element, the halogen ion may be dissociated from the ligand described above, and the halogen ion may be coordinated to the surfaces of the semiconductor quantum dots. In addition, a moiety of the ligand other than the halogen element described above may also be coordinated to the surfaces of the semiconductor quantum dots. To describe with a specific example, in a case of indium iodide, indium iodide may be coordinated to the surfaces of the semiconductor quantum dots, or an iodine ion or an indium ion may be coordinated to the surfaces of the semiconductor quantum dots.

The organic ligand may be a monodentate organic ligand having one coordination moiety or may be a multidentate organic ligand having two or more coordination moieties. Examples of the coordination moiety included in the

organic ligand include a thiol group, an amino group, a hydroxy group, a carboxy group, a sulfo group, a phospho group, and a phosphonic acid group. The organic ligand preferably contains a thiol group. As the organic ligand, an organic ligand containing a nitrogen element can also be used.

Specific examples of the monodentate organic ligand include oleylamine, ammonium acetate, 2-naphthylamine, 4-methylthioaniline, 4-methylbenzenethiol, 3,5-dimethylbenzenethiol, 4-chlorobenzenethiol, 4-methoxybenzenethiol, and benzoic acid.

Examples of the multidentate ligand include a ligand represented by any of Formulae (A) to (C).

$$X^{A1}\text{-}L^{A1}\text{-}X^{A2} \qquad \text{(A)}$$

$$X^{B1}\text{-}L^{B1}\text{-}X^{B3}\text{-}L^{B2}\text{-}X^{B2} \qquad \text{(B)}$$

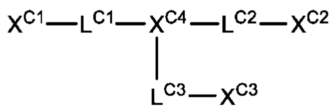

(C)

In Formula (A), $X^{A1}$ and $X^{A2}$ each independently represent a thiol group, an amino group, a hydroxy group, a carboxy group, a sulfo group, a phospho group, or a phosphonate group.

$L^{A1}$ represents a hydrocarbon group.

In Formula (B), $X^{B1}$ and $X^{B2}$ each independently represent a thiol group, an amino group, a hydroxy group, a carboxy group, a sulfo group, a phospho group, or a phosphonic acid group,

$X^{B3}$ represents S, O, or NH, and
$L^{B1}$ and $L^{B2}$ each independently represent a hydrocarbon group.

In Formula (C), $X^{C1}$ to $X^{C3}$ each independently represent a thiol group, an amino group, a hydroxy group, a carboxy group, a sulfo group, a phospho group, or a phosphonic acid group,

$X^{C4}$ represents N, and
$L^{C1}$ to $L^{C3}$ each independently represent a hydrocarbon group.

The amino group represented by $X^{A1}$, $X^{A2}$, $X^{B1}$, $X^{B2}$, $X^{C1}$, $X^{C2}$, or $X^{C3}$ is not limited to $-NH_2$ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably $-NH_2$, a monoalkylamino group, or a dialkylamino group, and more preferably $-NH_2$.

It is preferable that at least one of $X^{A1}$ or $X^{A2}$ in Formula (A) is a thiol group. The other may be a thiol group or may be a group other than the thiol group. The group other than the thiol group is preferably a carboxy group, an amino group, or a hydroxy group.

It is preferable that at least one of $X^{B1}$ or $X^{B2}$ in Formula (B) is a thiol group. The other may be a thiol group or may be a group other than the thiol group. The group other than the thiol group is preferably a carboxy group, an amino group, or a hydroxy group.

It is preferable that at least one of $X^{C1}$, $X^{C2}$, or $X^{C3}$ in Formula (C) is a thiol group. The other may be a thiol group or may be a group other than the thiol group. The group other than the thiol group is preferably a carboxy group, an amino group, or a hydroxy group.

The hydrocarbon group represented by $L^{A1}$, $L^{B1}$, $L^{B2}$, $L^{C1}$, $L^{C2}$, or $L^{C3}$ is preferably an aliphatic hydrocarbon group or a group including an aromatic ring, and more preferably the aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. An upper limit of the number of carbon atoms is preferably 10 or less, more preferably 6 or less, and still more preferably 3 or less. Specific examples of the hydrocarbon group include an alkylene group, an alkenylene group, an alkynylene group, and an arylene group.

Examples of the alkylene group include a linear alkylene group, a branched alkylene group, and a cyclic alkylene group. The linear alkylene group or the branched alkylene group is preferable, and the linear alkylene group is more

preferable. Examples of the alkenylene group include a linear alkenylene group, a branched alkenylene group, and a cyclic alkenylene group. The linear alkenylene group or the branched alkenylene group is preferable, and the linear alkenylene group is more preferable. Examples of the alkynylene group include a linear alkynylene group and a branched alkynylene group, and the linear alkynylene group is preferable. The arylene group may be a monocyclic ring or may be a polycyclic ring. The monocyclic arylene group is preferable. Specific examples of the arylene group include a phenylene group and a naphthylene group, and the phenylene group is preferable. The alkylene group, the alkenylene group, the alkynylene group, and the arylene group may further have a substituent. The substituent is preferably a group having 1 or more and 10 or less atoms. Preferred specific examples of the group having 1 or more and 10 or less of atoms include an alkyl group having 1 to 3 carbon atoms [a methyl group, an ethyl group, a propyl group, and an isopropyl group], an alkenyl group having 2 or 3 carbon atoms [an ethenyl group and a propenyl group], an alkynyl group having 2 to 4 carbon atoms [an ethynyl group, a propynyl group, and the like], a cyclopropyl group, an alkoxy group having 1 or 2 carbon atoms [a methoxy group and an ethoxy group], an acyl group having 2 or 3 carbon atoms [an acetyl group and a propionyl group], an alkoxycarbonyl group having 2 or 3 carbon atoms [a methoxycarbonyl group and an ethoxycarbonyl group], an acyloxy group having 2 carbon atoms [an acetyloxy group], an acylamino group having 2 carbon atoms [an acetylamino group], a hydroxyalkyl group having 1 to 3 carbon atoms [a hydroxymethyl group, a hydroxyethyl group, and a hydroxypropyl group], an aldehyde group, a hydroxy group, a carboxy group, a sulfo group, a phospho group, a carbamoyl group, a cyano group, an isocyanate group, a thiol group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), $X^{A1}$ and $X^{A2}$ are separated by $L^{A1}$, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (B), $X^{B1}$ and $X^{B3}$ are separated by $L^{B1}$, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, $X^{B2}$ and $X^{B3}$ are separated by $L^{B2}$, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (C), $X^{C1}$ and $X^{C4}$ are separated by $L^{C1}$, preferably by 1 to 10 atoms, more preferably by 1 to 6 atoms, still more preferably by 1 to 4 atoms, even still more preferably by 1 to 3 atoms, and particularly preferably by 1 or 2 atoms. Furthermore, $X^{C2}$ and $X^{C4}$ are separated by $L^{C2}$, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, $X^{C3}$ and $X^{C4}$ are separated by $L^{C3}$, preferably by 1 to 10 atoms, more preferably by 1 to 6 atoms, still more preferably by 1 to 4 atoms, even still more preferably by 1 to 3 atoms, and particularly preferably by 1 or 2 atoms.

Furthermore, the description that $X^{A1}$ and $X^{A2}$ are separated by $L^{A1}$ by 1 to 10 atoms means that the number of atoms constituting a molecular chain having the shortest distance, linking $X^{A1}$ and $X^{A2}$, is 1 to 10. For example, in a case of Formula (A1), $X^{A1}$ and $X^{A2}$ are separated by 2 atoms, and in cases of Formulae (A2) and (A3), $X^{A1}$ and $X^{A2}$ are separated by 3 atoms. The numbers added to the following structural formulae represent the arrangement order of atoms constituting a molecular chain having the shortest distance, linking $X^{A1}$ and $X^{A2}$.

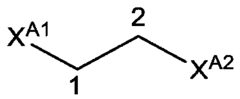

(A1)

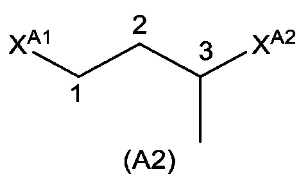

(A2)

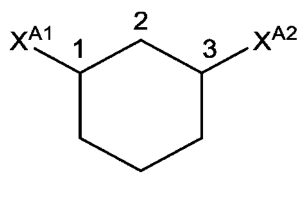

(A3)

To explain with a specific compound, 3-mercaptopropionic acid is a compound (a compound having the following structure) having a structure in which a moiety corresponding to $X^{A1}$ is a carboxy group, a moiety corresponding to $X^{A2}$ is a thiol group, and a moiety corresponding to $L^{A1}$ is an ethylene group. In 3-mercaptopropionic acid, $X^{A1}$ (carboxy group) and $X^{A2}$ (thiol group) are separated by $L^{A1}$ (ethylene group) by 2 atoms.

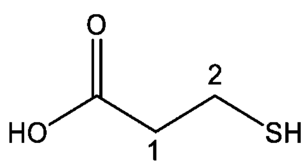

The same applies to the meanings that $X^{B1}$ and $X^{B3}$ are separated by $L^{B1}$ by 1 to 10 atoms, $X^{B2}$ and $X^{B3}$ are separated by $L^{B2}$ by 1 to 10 atoms, $X^{C1}$ and $X^{C4}$ are separated by $L^{C1}$ by 1 to 10 atoms, $X^{C2}$ and $X^{C4}$ are separated by $L^{C2}$ by

1 to 10 atoms, and $X^{C3}$ and $X^{C4}$ are separated by $L^{C3}$ by 1 to 10 atoms.

Specific examples of the multidentate ligand include 3-mercaptopropionic acid, thioglycolic acid, 2-aminoethanol, 2-aminoethanethiol, 2-mercaptoethanol, glycolic acid, ethylene glycol, ethylenediamine, aminosulfonic acid, glycine, aminomethylphosphoric acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol, 1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine, 1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D-tartaric acid, tartronic acid, 1,2-benzenedithiol, 1,3-benzenedithiol, 1,4-benzenedithiol, 2-mercaptobenzoic acid, 3-mercaptobenzoic acid, 4-mercaptobenzoic acid, and derivatives thereof.

In the semiconductor film according to the embodiment of the present invention, the total content of the semiconductor quantum dots and the ligand is preferably 80% by mass or more, more preferably 90% by mass or more, and still more preferably 95% by mass or more.

<Method for Manufacturing Semiconductor Film>

The semiconductor film according to the embodiment of the present invention can be manufactured through a step of applying a dispersion liquid containing the above-described semiconductor quantum dots, a solvent, and a ligand onto a substrate.

Examples of the semiconductor quantum dots contained in the dispersion liquid include the semiconductor quantum dots described in the section of the semiconductor film described above, and the same applies to the preferred range thereof. The content of the semiconductor quantum dots in the dispersion liquid is preferably 10 to 500 mg/mL. The lower limit thereof is preferably 50 mg/mL or more and more preferably 80 mg/mL or more. The upper limit thereof is preferably 300 mg/mL or less and more preferably 200 mg/mL or less.

Examples of the ligand contained in the dispersion liquid include the ligand described in the section of the semiconductor film described above.

The dispersion liquid may contain a ligand that acts as a ligand that is coordinated to the semiconductor quantum dots and concurrently has a molecular structure that easily causes steric hindrance, thereby also serving as a dispersing agent that disperses the semiconductor quantum dots in the solvent. Examples of such a ligand include a ligand having a main chain that has at least 6 or more carbon atoms, and a ligand having a main chain having 10 or more carbon atoms is preferable. The ligand may be a saturated compound or may be an unsaturated compound. Specific examples thereof include decanoic acid, lauric acid, myristic acid, palmitic acid, stearic acid, behenic acid, oleic acid, erucic acid, oleylamine, stearylamine, 1-aminodecane, dodecylamine, aniline, dodecanethiol, 1,2-hexadecanethiol, tributylphosphine, trihexylphosphine, trioctylphosphine, tributylphosphine oxide, trioctylphosphine oxide, and cetrimonium bromide.

A content of the ligand in the dispersion liquid is preferably 0.2 mol/L to 3.0 mol/L, and more preferably 0.2 mol/L to 0.5 mol/L.

The solvent contained in the dispersion liquid is not particularly limited; however, it is preferably a solvent that hardly dissolves the semiconductor quantum dots and easily dissolves the ligand. The solvent is preferably an organic solvent. Specific examples thereof include alkanes (n-hexane, n-octane, and the like), alkenes (octadecene and the like), benzene, and toluene. The solvent contained in the dispersion liquid according to the embodiment of the present invention may be only one kind or may be a mixed solvent in which two or more kinds are mixed.

The content of the solvent in the dispersion liquid is preferably 50% to 99% by mass, more preferably 70% to 99% by mass, and still more preferably 90% to 98% by mass.

The shape, structure, size, and the like of the substrate onto which the dispersion liquid is applied are not particularly limited and can be appropriately selected according to the intended purpose. The structure of the substrate may be a monolayer structure or may be a laminated structure. As the substrate, for example, a substrate composed of an inorganic material such as silicon, glass, or yttria-stabilized zirconia (YSZ), a resin, a resin composite material, or the like can be used. In addition, an electrode, an insulating film, or the like may be formed on the substrate. In this case, the dispersion liquid is also applied onto the electrode or the insulating film on the substrate.

The method for applying a dispersion liquid onto a substrate is not particularly limited. Examples thereof include coating methods such as a spin coating method, a dipping method, an ink jet method, a dispenser method, a screen printing method, a relief printing method, an intaglio printing method, and a spray coating method.

The film thickness of the film of aggregates of the semiconductor quantum dots formed by applying the dispersion liquid is preferably 3 nm or more, more preferably 10 nm or more, and still more preferably 20 nm or more. The upper limit thereof is preferably 200 nm or less, more preferably 150 nm or less, and still more preferably 100 nm or less.

After forming the film of aggregates of the semiconductor quantum dots, a step of applying a ligand solution to the

film described above may be carried out. In a case where this step is carried out, the ligand coordinated to the semiconductor quantum dots can be exchanged with a ligand contained in the ligand solution, or a ligand contained in the ligand solution can be coordinated to the semiconductor quantum dots to suppress the generation of surface defects of the semiconductor quantum dots. The step of applying the dispersion liquid and the step of applying the ligand solution may be alternately repeated a plurality of times.

Examples of the ligand contained in the ligand solution include the ligand described in the section of the semiconductor film described above. The ligand contained in the ligand solution may be the same as or different from the ligand contained in the dispersion liquid. The ligand solution may contain only one kind or two or more kinds of the ligands. In addition, in the step of applying the ligand solution, two or more kinds of the ligand solutions may be used.

The solvent contained in the ligand solution is preferably selected appropriately according to the kind of the ligand contained in each ligand solution, and it is preferably a solvent that easily dissolves each ligand. In addition, the solvent contained in the ligand solution is preferably an organic solvent having a high permittivity. Specific examples thereof include ethanol, acetone, methanol, acetonitrile, dimethylformamide, dimethyl sulfoxide, butanol, and propanol. In addition, the solvent contained in the ligand solution is preferably a solvent that does not easily remain in the formed semiconductor film. From the viewpoints of easy drying and easy removal by washing, a low boiling point alcohol, a ketone, or a nitrile is preferable, and methanol, ethanol, acetone, or acetonitrile is more preferable. The solvent contained in the ligand solution is preferably one that does not mix with the solvent contained in the quantum dot dispersion liquid. With regard to a preferred combination of the solvents, in a case where the solvent contained in the quantum dot dispersion liquid is an alkane such as hexane and octane, or toluene, it is preferable to use a polar solvent such as methanol and acetone as the solvent contained in the ligand solution.

A step of bringing a rinsing liquid into contact with the film (rinsing step) after performing the step of applying the ligand solution may be performed. In a case where the rinsing step is carried out, it is possible to remove the excessive ligand contained in the semiconductor film and the ligand eliminated from the semiconductor quantum dots. In addition, the rinsing step may be performed a plurality of times by using two or more kinds of rinsing liquids that differ in polarity (relative permittivity). For example, it is preferable that first, a rinsing liquid having a high relative permittivity (also referred to as a first rinsing liquid) is used to perform rinsing, and then a rinsing liquid having a relative permittivity lower than that of the first rinsing liquid (also referred to as a second rinsing liquid) is used to perform rinsing. The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

The method for manufacturing a semiconductor film may include a drying step. In a case of carrying out the drying step, it is possible to remove the solvent remaining on the semiconductor film. The drying time is preferably 1 to 100 hours, more preferably 1 to 50 hours, and still more preferably 5 to 30 hours. The drying temperature is preferably 10°C to 100°C, more preferably 20°C to 90°C, and still more preferably 20°C to 60°C. The drying step may be performed in an atmosphere containing oxygen or in a nitrogen atmosphere. The amount of the residual solvent contained in the semiconductor film is preferably 5% by mass or less, more preferably 3% by mass or less, and still more preferably 1% by mass or less with respect to the total amount of the semiconductor film. The lower limit thereof may be, for example, 0.0001% by mass. The semiconductor film may contain water, and it is preferably 5% by mass or less, more preferably 3% by mass or less, and still more preferably 1% by mass or less with respect to the total amount of the semiconductor film. The lower limit thereof may be, for example, 0.0001% by mass. In the manufacturing step of the semiconductor film, the semiconductor quantum dots and the ligand may be oxidized.

<Photodetector>

The photodetector according to the embodiment of the present invention includes the above-described semiconductor film according to the embodiment of the present invention. Preferably, the photodetector includes the semiconductor film according to the embodiment of the present invention as a photoelectric conversion layer of the photodetector.

Examples of the type of photodetector include a photoconductor-type photodetector and a photodiode-type photodetector. Among the above, a photodiode-type photodetector is preferable for the reason that a high signal-to-noise ratio (SN ratio) is easily obtained.

Since the semiconductor film according to the embodiment of the present invention has excellent sensitivity to the light having a wavelength in the infrared region, a photodetector in which this semiconductor film is used for a photoelectric conversion layer is preferably used as a photodetector that detects light having a wavelength in the infrared region. That is, the photodetector is preferably used as an infrared photodetector.

The light having a wavelength in the infrared region is preferably light having a wavelength of more than 700 nm, more preferably light having a wavelength of 800 nm or more, and still more preferably light having a wavelength of 900 nm or more. In addition, the light having a wavelength in the infrared region is preferably light having a wavelength of 3,000 nm or less, more preferably light having a wavelength of 2,000 nm or less, and still more preferably light having a wavelength of

1,600 nm or less.

The photodetector may be a photodetector that simultaneously detects light having a wavelength in the infrared region and light having a wavelength in the visible region (preferably light having a wavelength range of 400 to 700 nm).

FIG. 1 is a view illustrating an embodiment of a photodetector. FIG. 1 is a view illustrating an embodiment of a photodiode-type photodetector. Furthermore, an arrow in the drawing represents the incident ray on the photodetector. A photodetector 1 illustrated in FIG. 1 includes a second electrode 12, a first electrode 11 provided to face the second electrode 12, a photoelectric conversion layer 13 provided between the second electrode 12 and the first electrode 11, an electron transport layer 21 provided between the first electrode 11 and the photoelectric conversion layer 13, and a hole transport layer 22 provided between the second electrode 12 and the photoelectric conversion layer 13. The photodetector 1 illustrated in FIG. 1 is used with light incident from above the first electrode 11. Although not illustrated in the drawing, a transparent substrate may be disposed on the surface of the first electrode 11 on the light incident side. Examples of the kind of transparent substrate include a glass substrate, a resin substrate, and a ceramic substrate.

(First Electrode)

The first electrode 11 is preferably a transparent electrode formed of a conductive material that is substantially transparent with respect to the wavelength of target light to be detected by the photodetector. Furthermore, in the present specification, the description of "substantially transparent" means that the transmittance of light is 50% or more, preferably 60% or more, and more preferably 80% or more. Examples of the material of the first electrode 11 include a conductive metal oxide. Specific examples thereof include tin oxide, zinc oxide, indium oxide, indium tungsten oxide, indium zinc oxide (IZO), indium tin oxide (ITO), and a fluorine-doped tin oxide (FTO).

The film thickness of the first electrode 11 is not particularly limited, and it is preferably 0.01 to 100 μm, more preferably 0.01 to 10 μm, and still more preferably 0.01 to 1 μm. The film thickness of each layer can be measured by observing the cross section of the photodetector 1 using a scanning electron microscope (SEM) or the like.

(Electron Transport Layer)

The electron transport layer 21 is a layer having a function of transporting electrons generated in the photoelectric conversion layer 13 to the electrode. The electron transport layer is also called a hole block layer. The electron transport layer is formed of an electron transport material capable of exhibiting this function.

Examples of the electron transport material include fullerene compounds such as [6,6]-phenyl-C61-butyric acid methyl ester (PC61BM), perylene compounds such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport material may be a particle. The electron transport material is preferably zinc oxide. In addition, from the viewpoint of reducing the organic residual component and increasing the area for contact with the photoelectric conversion layer, the zinc oxide is preferably a particle (zinc oxide particle).

The zinc oxide may be a zinc oxide doped with a metal atom other than Zn. Hereinafter, the zinc oxide doped with a metal atom other than Zn is also referred to as the doped zinc oxide.

The metal atom other than Zn in the doped zinc oxide is preferably a monovalent to trivalent metal atom, more preferably a metal atom including at least one selected from Li, Mg, Al, or Ga, still more preferably Li, Mg, Al, or Ga, and particularly preferably Li or Mg.

In the doped zinc oxide, a proportion of the metal atoms other than Zn to a total of Zn and the metal atoms other than Zn is preferably 1% by atom or more, more preferably 2% by atom or more, and still more preferably 4% by atom or more. From the viewpoint of suppressing an increase in crystal defects, an upper limit of the proportion is preferably 20% by atom or less, more preferably 15% by atom or less, and still more preferably 12% by atom or less. Furthermore, a proportion of the metal atoms other than Zn in the doped zinc oxide can be measured according to a high-frequency inductively coupled plasma (ICP) method.

An average particle diameter of the zinc oxide particles is preferably 2 to 30 nm. In addition, the upper limit value of the average particle diameter of the zinc oxide particles is preferably 20 nm or less and more preferably 15 nm or less. In a case where the average particle diameter of the zinc oxide particles is within the above-described range, it is easy to obtain a film that has a large area for contact with the photoelectric conversion layer and has a high flatness. In the present specification, the value of the average particle diameter of the zinc oxide particles is an average value of 10 particle diameters which are randomly selected. A transmission electron microscope may be used to measure the particle diameters of the zinc oxide particles.

The electron transport layer may be a single-layer film or a laminated film having two or more layers. A thickness of the electron transport layer is preferably 10 to 1,000 nm. An upper limit thereof is preferably 800 nm or less. A lower limit thereof is preferably 20 nm or more, and more preferably 50 nm or more. In addition, the thickness of the electron transport layer is preferably 0.05 to 10 times, more preferably 0.1 to 5 times, and still more preferably 0.2 to 2 times the thickness of

the photoelectric conversion layer 13.

The electron transport layer may be subjected to ultraviolet ozone treatment. In particular, in a case of a layer consisting of nanoparticles as the electron transport layer, it is desirable to carry out ultraviolet ozone treatment. In a case where the ultraviolet ozone treatment is carried out, it is possible to improve the wettability of the quantum dot dispersion liquid on the electron transport layer and decompose or remove the residual organic substances in the electron transport layer, which makes it possible to obtain high element performance. The wavelength of the ultraviolet rays for irradiation can be selected in a wavelength range of 100 to 400 nm. In particular, for the reason that the above-described effect is easily obtained and excessive damage to a film can be avoided, it is preferable that the peak intensity is present in a wavelength range of 200 to 300 nm, and it is more preferable that the peak intensity is present in a wavelength range of 240 to 270 nm. The irradiation intensity of the ultraviolet rays is not particularly limited; however, it is preferably 1 to 100 $mW/cm^2$ and more preferably 10 to 50 $mW/cm^2$ for the reason that the above-described effect is easily obtained and excessive damage to a film can be avoided. The treatment time is not particularly limited; however, it is preferably 1 to 60 minutes, more preferably 1 to 20 minutes, and still more preferably 3 to 15 minutes, for the same reason as described above.

(Photoelectric Conversion Layer)

The photoelectric conversion layer 13 is composed of the above-described semiconductor film according to the embodiment of the present invention. The thickness of the photoelectric conversion layer 13 is preferably 10 to 1,000 nm. The lower limit of the thickness is preferably 20 nm or more and more preferably 30 nm or more. The upper limit of the thickness is preferably 600 nm or less, more preferably 550 nm or less, still more preferably 500 nm or less, and particularly preferably 450 nm or less. The refractive index of the photoelectric conversion layer 13 with respect to light having a target wavelength to be detected by the photodetector can be set to 1.5 to 5.0.

(Hole Transport Layer)

The hole transport layer 22 is a layer having a function of transporting holes generated in the photoelectric conversion layer 13 to the electrode. The hole transport layer is also called an electron block layer.

The hole transport layer 22 is formed of a hole transport material capable of exhibiting this function. Examples of the hole transport material include PEDOT:PSS (a complex of poly(3,4-ethylenedioxythiophene) and poly(4-styrenesulfonic acid)), PTB7 (poly{4,8-bis[(2-ethylhexyl)oxy]benzo[1,2-b:4,5-b']dithiophen-2,6-diyl-lt-alt-3-fluoro-2-[(2-et hylhexyl)carbonyl]thieno[3,4-b]thiophen-4,6-diyl}), PTB7-Th (poly([2,6'-4,8-di(5-ethylhexylthienyl)benzo[1,2-b;3,3-b]dithiophen]{3-fluoro-2-[(2-ethylhexy l 1)carbonyl]thieno[3,4-b]thiophendiyl)), poly(3-hexylthiophene-2,5-diyl), poly(3-n-octyloxythiophene), poly(9,9'-dioctyl-fluorene-co-bithiophene), poly(3,3'''-didodecyl-quaterthiophene), poly(3,6-dioctylthieno[3,2-b]thiophene), poly(2,5-bis(3-decylthiophene-2-yl)thieno[3,2-b]thiophene), poly(3,4-didecylthiophene-co-thieno [3,2-b]thiophene), poly(3,6-dioctylthieno[3,2-b]thiophene-co-thieno[3,2-b]thiophene), poly(3,6-dioctylthieno[3,2-b]thiophene-co-thiophene), poly(3,6-dioctylthieno[3,2-b]thiophene-co-bithiophene), and PC71BM ([6,6]-phenyl-C71-methyl butyrate). Furthermore, the organic hole transport material disclosed in paragraph Nos. 0209 to 0212 of JP2001-291534A can also be used. In addition, quantum dots can also be used in the hole transport material. Examples of the quantum dot material constituting the quantum dot include nanoparticles (a particle having a size of 0.5 nm or more and less than 100 nm) of general semiconductor crystals [a) a Group IV semiconductor, b) a compound semiconductor of Group IV-IV, Group III-V, or Group II-VI, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbSeS, InN, Ge, InAs, InGaAs, CuInS, CuInSe, CuInGaSe, InSb, HgTe, HgCdTe, $Ag_2S$, $Ag_2Se$, $Ag_2Te$, SnS, SnSe, SnTe, Si, and InP. A ligand may be coordinated to surfaces of the quantum dots.

The thickness of the hole transport layer 22 is preferably 5 to 100 nm. A lower limit thereof is preferably 10 nm or more. An upper limit thereof is preferably 50 nm or less and more preferably 30 nm or less.

(Second Electrode)

The second electrode 12 is preferably composed of a metal material including at least one metal atom selected from Ag, Au, Pt, Ir, Pd, Cu, Pb, Sn, Zn, Ti, W, Mo, Ta, Ge, Ni, Al, Cr, or In. Since the second electrode 12 is composed of such a metal material, it is possible for the photodetector to have a high external quantum efficiency and further suppressed dark current. In addition, the above-described conductive metal oxide, a carbon material, a conductive polymer, and the like can also be used for the second electrode 12. The carbon material may be any material having conductivity, and examples thereof include fullerene, a carbon nanotube, graphite, and graphene.

The work function of the second electrode 12 is preferably 4.6 eV or more, more preferably 4.8 to 5.7 eV, and still more preferably 4.9 to 5.3 eV, for the reason that the electron blocking property due to the hole transport layer is increased

and the holes generated in the element are easily collected.

The film thickness of the second electrode 12 is not particularly limited, and it is preferably 0.01 to 100 μm, more preferably 0.01 to 10 μm, and still more preferably 0.01 to 1 μm.

(Charge Extraction Layer)

Although not shown, the photodetector according to the embodiment of the present invention may have a charge extraction layer between the second electrode 12 and the hole transport layer 22. By providing the charge extraction layer, a high external quantum efficiency can be obtained at a low applied voltage.

Examples of the material forming the charge extraction layer include a metal oxide and an organic semiconductor, and a metal oxide is preferable. Examples of the metal oxide include molybdenum oxide, titanium oxide, vanadium oxide, chromium oxide, cobalt oxide, nickel oxide, copper oxide, zirconium oxide, molybdenum oxide, silver oxide, tantalum oxide, and tungsten oxide, and molybdenum oxide is preferable. Examples of the organic semiconductor include a polythiophene compound. Specific examples of the polythiophene compound include the above-described materials. The charge extraction layer may be a single-layer film or a laminated film having two or more layers.

The film thickness of the charge extraction layer is preferably 1 to 100 nm. A lower limit thereof is preferably 5 nm or more. An upper limit thereof is preferably 50 nm or less.

(Blocking Layer)

Although not illustrated in the drawing, the photodetector may have a blocking layer between the first electrode 11 and the electron transport layer 21. The blocking layer is a layer having a function of preventing a reverse current. The blocking layer is also called a short circuit prevention layer. Examples of the material that forms the blocking layer include silicon oxide, magnesium oxide, aluminum oxide, calcium carbonate, cesium carbonate, polyvinyl alcohol, polyurethane, titanium oxide, tin oxide, zinc oxide, niobium oxide, and tungsten oxide. The blocking layer may be a single-layer film or a laminated film having two or more layers. The film thickness of the blocking layer is preferably 5 to 100 nm. A lower limit thereof is preferably 10 nm or more. An upper limit thereof is preferably 50 nm or less and more preferably 30 nm or less.

In the photodetector, a wavelength λ of the target light to be detected by the photodetector and an optical path length $L^{\lambda}$ of the light having the wavelength λ from the surface of the second electrode 12 on the side of the photoelectric conversion layer 13 to the surface of the photoelectric conversion layer 13 on the side of the first electrode 11 preferably satisfy the relationship of Expression (1-1), and more preferably satisfy the relationship of Expression (1-2). In a case where the wavelength λ and the optical path length $L^{\lambda}$ satisfy such a relationship, in the photoelectric conversion layer 13, it is possible to arrange phases of the light (incident ray) incident from the side of the first electrode 11 and phases of the light (reflected light) reflected on the surface of the second electrode 12, and as a result, the light is intensified by the optical interference effect, whereby it is possible to obtain a higher external quantum efficiency.

$$0.05 + m/2 \leq L^{\lambda}/\lambda \leq 0.35 + m/2 \qquad \cdots(1\text{-}1)$$

$$0.10 + m/2 \leq L^{\lambda}/\lambda \leq 0.30 + m/2 \qquad \cdots(1\text{-}2)$$

In the above expressions, λ is the wavelength of the target light to be detected by the photodetector,

$L^{\lambda}$ is the optical path length of the light having the wavelength λ from a surface of the second electrode 12 on a side of the photoelectric conversion layer 13 to a surface of the photoelectric conversion layer 13 on a side of the first electrode 11, and
m is an integer of 0 or more.

m is preferably an integer of 0 to 4, more preferably an integer of 0 to 3, and still more preferably an integer of 0 to 2. According to this aspect, the transport characteristics of charges such as the hole and the electron are good, and thus it is possible to increase the external quantum efficiency of the photodetector.

Here, the optical path length means the product obtained by multiplying the physical thickness of a substance through which light transmits by the refractive index. To make a description with the photoelectric conversion layer 13 as an example, in a case where the thickness of the photoelectric conversion layer is denoted by $d^1$ and the refractive index of the photoelectric conversion layer with respect to light having a wavelength $\lambda^1$ is denoted by $N^1$, the optical path length of the light having the wavelength $\lambda^1$ and transmitting through the photoelectric conversion layer 13 is $N^1 \times d^1$. In a case where the photoelectric conversion layer 13 or the hole transport layer 22 is composed of laminated films having two or more layers or in a case where an interlayer is present between the hole transport layer 22 and the second electrode 12, the

integrated value of the optical path length of each layer is the optical path length $L^{\lambda}$.

<Image Sensor>

The image sensor according to the embodiment of the present invention includes the above-described photodetector according to the embodiment of the present invention. This image sensor can be particularly preferably used as an infrared sensor since the photodetector according to the embodiment of the present invention has excellent sensitivity to light having a wavelength in the infrared region. In addition, the image sensor can be preferably used as a sensor for sensing light having a wavelength of 900 to 3,000 nm, can be more preferably used as a sensor for sensing light having a wavelength of 900 to 2,000 nm, and can be still more preferably used as a sensor for sensing light having a wavelength of 900 to 1,600 nm.

The configuration of the image sensor is not particularly limited as long as it comprises the photodetector and it is a configuration that functions as an image sensor. Examples of the photodetector include the above-described photodetector.

The image sensor may include an infrared transmitting filter layer. The infrared transmitting filter layer preferably has a low light transmittance in the wavelength band of the visible region, more preferably has an average light transmittance of 10% or less, still more preferably 7.5% or less, and particularly preferably 5% or less, in a wavelength range of 400 to 650 nm.

Examples of the infrared transmitting filter layer include those composed of a resin film containing a coloring material. Examples of the coloring material include a chromatic coloring material such as a red coloring material, a green coloring material, a blue coloring material, a yellow coloring material, a purple coloring material, and an orange coloring material, and a black coloring material. It is preferable that the coloring material contained in the infrared transmitting filter layer forms a black color with a combination of two or more kinds of chromatic coloring materials or is a coloring material containing a black coloring material. Examples of the combination of the chromatic coloring material in a case of forming a black color by a combination of two or more kinds of chromatic coloring materials include the following aspects (C1) to (C7).

(C1) An aspect containing a red coloring material and a blue coloring material.
(C2) An aspect containing a red coloring material, a blue coloring material, and a yellow coloring material.
(C3) An aspect containing a red coloring material, a blue coloring material, a yellow coloring material, and a purple coloring material.
(C4) An aspect containing a red coloring material, a blue coloring material, a yellow coloring material, a purple coloring material, and a green coloring material.
(C5) An aspect containing a red coloring material, a blue coloring material, a yellow coloring material, and a green coloring material.
(C6) An aspect containing a red coloring material, a blue coloring material, and a green coloring material.
(C7) An aspect containing a yellow coloring material and a purple coloring material.

The chromatic coloring material may be a pigment or a dye. The chromatic coloring material may contain a pigment and a dye. The black coloring material is preferably an organic black coloring material. Examples of the organic black coloring material include a bisbenzofuranone compound, an azomethine compound, a perylene compound, and an azo compound.

The infrared transmitting filter layer may further contain an infrared absorber. In a case where the infrared absorber is contained in the infrared transmitting filter layer, the wavelength of the light to be transmitted can be shifted to the longer wave side. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride.

The spectral characteristics of the infrared transmitting filter layer can be appropriately selected according to the use application of the image sensor. Examples of the filter layer include those that satisfy any one of the following spectral characteristics of (1) to (5).

(1): A filter layer in which the maximum value of the light transmittance in the film thickness direction in a wavelength range of 400 to 750 nm is 20% or less (preferably 15% or less and more preferably 10% or less), and the minimum value of the light transmittance in the film thickness direction in a wavelength range of 900 to 1,500 nm is 70% or more (preferably 75% or more and more preferably 80% or more).
(2): A filter layer in which the maximum value of the light transmittance in the film thickness direction in a wavelength range of 400 to 830 nm is 20% or less (preferably 15% or less and more preferably 10% or less), and the minimum

value of the light transmittance in the film thickness direction in a wavelength range of 1,000 to 1,500 nm is 70% or more (preferably 75% or more and more preferably 80% or more).

(3): A filter layer in which the maximum value of the light transmittance in the film thickness direction in a wavelength range of 400 to 950 nm is 20% or less (preferably 15% or less and more preferably 10% or less), and the minimum value of the light transmittance in the film thickness direction in a wavelength range of 1,100 to 1,500 nm is 70% or more (preferably 75% or more and more preferably 80% or more).

(4): A filter layer in which the maximum value of the light transmittance in the film thickness direction in a wavelength range of 400 to 1,100 nm is 20% or less (preferably 15% or less and more preferably 10% or less), and the minimum value thereof in a wavelength range of 1,400 to 1,500 nm is 70% or more (preferably 75% or more and more preferably 80% or more).

(5): A filter layer in which the maximum value of the light transmittance in the film thickness direction in a wavelength range of 400 to 1,300 nm is 20% or less (preferably 15% or less and more preferably 10% or less), and the minimum value thereof in a wavelength range of 1,600 to 2,000 nm is 70% or more (preferably 75% or more and more preferably 80% or more).

Further, as the infrared transmitting filter, the films disclosed in JP2013-077009A, JP2014-130173A, JP2014-130338A, WO2015/166779A, WO2016/178346A, WO2016/190162A, WO2018/016232A, JP2016-177079A, JP2014-130332A, and WO2016/027798A can be used. As the infrared transmitting filter, two or more filters may be used in combination, or a dual bandpass filter that transmits through two or more specific wavelength regions with one filter may be used.

The image sensor may include an infrared shielding filter for the intended purpose of improving various performances such as noise reduction. Specific examples of the infrared shielding filter include the filters disclosed in WO2016/186050A, WO2016/035695A, JP6248945B, WO2019/021767A, JP2017-067963A, and JP6506529B.

The image sensor may include a dielectric multi-layer film. Examples of the dielectric multi-layer film include those in which a plurality of layers are laminated by alternately laminating a dielectric thin film having a high refractive index (a high refractive index material layer) and a dielectric thin film having a low refractive index (a low refractive index material layer). The number of lamination layers of the dielectric thin film in the dielectric multi-layer film is not particularly limited, but is preferably 2 to 100 layers, more preferably 4 to 60 layers, and still more preferably 6 to 40 layers. The material that is used for forming the high refractive index material layer is preferably a material having a refractive index of 1.7 to 2.5. Specific examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS, and $ZrO_2$. The material that is used for forming the low refractive index material layer is preferably a material having a refractive index of 1.2 to 1.6. Specific examples thereof include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$, $ThF_4$, and $Na_3AlF_6$. The method for forming the dielectric multi-layer film is not particularly limited; however, examples thereof include ion plating, a vacuum vapor deposition method using an ion beam or the like, a physical vapor deposition method (PVD method) such as sputtering, and a chemical vapor deposition method (CVD method). The thickness of each of the high refractive index material layer and the low refractive index material layer is preferably 0.1 $\lambda$ to 0.5 $\lambda$ in a case where the wavelength of the light to be blocked is $\lambda$ (nm). Specific examples of the usable dielectric multi-layer film include the films disclosed in JP2014-130344A and JP2018-010296A.

In the dielectric multi-layer film, the transmission wavelength range is preferably present in the infrared region (preferably a wavelength range having a wavelength of more than 700 nm, more preferably a wavelength range having a wavelength of more than 800 nm, and still more preferably a wavelength range having a wavelength of more than 900 nm). The maximum transmittance in the transmission wavelength range is preferably 70% or more, more preferably 80% or more, and still more preferably 90% or more. In addition, the maximum transmittance in the shielding wavelength range is preferably 20% or less, more preferably 10% or less, and still more preferably 5% or less. In addition, the average transmittance in the transmission wavelength range is preferably 60% or more, more preferably 70% or more, and still more preferably 80% or more. In addition, in a case where the wavelength at which the maximum transmittance is exhibited is denoted by a central wavelength $\lambda_{t1}$, the wavelength range of the transmission wavelength range is preferably the central wavelength $\lambda_{t1} \pm 100$ nm, more preferably the central wavelength $\lambda_{t1} \pm 75$ nm, and still more preferably the central wavelength $\lambda_{t1} \pm 50$ nm.

The dielectric multi-layer film may have only one transmission wavelength range (preferably, a transmission wavelength range having a maximum transmittance of 90% or more) or may have a plurality of transmission wavelength ranges.

The image sensor may include a color separation filter layer. Examples of the color separation filter layer include a filter layer including colored pixels. Examples of the kind of colored pixel include a red pixel, a green pixel, a blue pixel, a yellow pixel, a cyan pixel, and a magenta pixel. The color separation filter layer may include colored pixels having two or more colors or having only one color. It can be appropriately selected according to the use application and the intended purpose. For example, the filter disclosed in WO2019/039172A can be used.

In addition, in a case where the color separation layer includes colored pixels having two or more colors, the

colored pixels of the respective colors may be adjacent to each other, or a partition wall may be provided between the respective colored pixels. The material of the partition wall is not particularly limited. Examples thereof include organic materials such as a siloxane resin and a fluororesin, and inorganic particles such as a silica particle. In addition, the partition wall may be composed of a metal such as tungsten and aluminum.

It is noted that in a case where the image sensor includes an infrared transmitting filter layer and a color separation layer, it is preferable that the color separation layer is provided on an optical path different from the infrared transmitting filter layer. In addition, it is also preferable that the infrared transmitting filter layer and the color separation layer are disposed in a two-dimensional manner. It is noted that the description that the infrared transmitting filter layer and the color separation layer are disposed two-dimensionally means that at least parts of both are present on the same plane.

The image sensor may include an interlayer such as a planarizing layer, an underlying layer, or an intimate attachment layer, an anti-reflection film, and a lens. As the anti-reflection film, for example, a film produced from the composition disclosed in WO2019/017280A can be used. As the lens, for example, the structure disclosed in WO2018/092600A can be used.

## Examples

Hereinafter, the present invention will be described in detail with reference to Examples. Materials, amounts used, proportions, treatment details, treatment procedures, and the like shown in the following examples can be appropriately changed without departing from the gist of the present invention. Therefore, the scope of the present invention is not limited to the specific examples described below.

[Production of Zinc Oxide Particle Dispersion Liquid]

1.5 mmol of zinc acetate dihydrate and 15 mL of dimethyl sulfoxide (DMSO) were measured and put in a flask, stirred, and dissolved to obtain a zinc acetate solution.

A tetramethylammonium chloride (TMACl) solution obtained by dissolving 4 mmol of TMACl in 4 mL of methanol and a potassium hydroxide (KOH) solution obtained by dissolving 4 mmol of KOH in 4 mL of methanol were produced. The KOH solution was slowly introduced while vigorously stirring the TMACl solution, and after stirring for 30 minutes, insoluble components were removed through a filter of 0.45 μm to obtain a tetramethylammonium hydroxide (TMAH) solution.

6 mL of the TMAH solution was added to the zinc acetate solution contained in the flask at a dropwise addition rate of 6 mL/min. After being held for 1 hour, the reaction solution was recovered. An excessive amount of acetone was added to the reaction solution, centrifugal separation was carried out at 10,000 rpm for 10 minutes. Then, the supernatant was removed, and the precipitate was dispersed in methanol. Then, the precipitate was precipitated again with acetone, 5 mL of ethanol and 80 μL of aminoethanol were added thereto, and ultrasonic dispersion was carried out to obtain a zinc oxide particle dispersion liquid in which the concentration of the non-doped zinc oxide particles was 30 mg/mL.

[Production of Quantum Dot Dispersion Liquid]

(Quantum Dot Dispersion Liquid 1)

5 mmol of indium chloride was added to 50 mL of oleylamine in a glove box, and the resultant mixture was heated and stirred at 60°C to dissolve the indium chloride, thereby preparing an indium precursor solution A.

5 mmol of antimony chloride was added to 20 mL of oleylamine in a glove box, and the resultant mixture was heated and stirred at 60°C to dissolve the antimony chloride, thereby preparing an antimony precursor solution B.

In a glove box, 100 mL of a tetrahydrofuran (THF) solution of lithium triethylborohydride (concentration of lithium triethylborohydride: 1.0 mol/L, manufactured by Sigma-Aldrich Co., LLC.) was mixed with 50 mL of dioctyl ether, and THF was distilled off to prepare a solution C which is a dioctyl ether solution of lithium triethylborohydride (concentration of lithium triethylborohydride: about 2.0 mol/L).

In a glove box, 16.5 mL of the precursor solution A, 3 mL of the precursor solution B, and 13.5 mL of oleylamine were added to a three-neck flask to obtain a mixed solution. Then, the three-neck flask was taken out from the glove box and repeatedly subjected to vacuuming and nitrogen purging, and then the state thereof was transitioned to a nitrogen flow state. Here, 2.9 mL of the solution C was injected into the mixed solution, the temperature was raised to 260°C at a rate of 3°C/min, the liquid temperature was maintained for about 15 minutes after reaching 260°C, and then the reaction solution was cooled. The three-neck flask was put into the glove box again, and 6 mL of oleic acid and 90 mL of toluene were added thereto and stirred. The solution was centrifuged at about 8,000 rpm, and the precipitate was removed. 60 mL of acetonitrile was added to the supernatant liquid, and the mixture was centrifuged again at 8,000 rpm. 9 mL of toluene was added to the precipitate to obtain a quantum dot dispersion liquid 1 which was a dispersion liquid of InSb quantum dots. A quantum dot thin film was produced using the obtained quantum dot dispersion liquid 1, and as a result of estimating the

band gap from the wavelength at which the inflection point of absorption was observed from the absorption measurement of the quantum dot thin film, it was approximately 0.99 eV.

(Quantum Dot Dispersion Liquid 2)

9 mL of acetonitrile was added to 9 mL of the quantum dot dispersion liquid 1, and the mixture was centrifuged. Then, the supernatant was removed, and the precipitate was recovered. Octane was added to the recovered precipitate to obtain a quantum dot dispersion liquid 2a having a concentration of 9 mg/ml.

Separately, 0.38 mL of 3-mercaptopropionic acid (MPA) was added to 5 mL of N,N-dimethylformamide (DMF) and dissolved to produce an MPA ligand exchange solution 1.

4 mL of the MPA ligand exchange solution 1 and 4 mL of the quantum dot dispersion liquid 2a were added to a centrifuge tube, and the mixture was stirred with a vortex mixer for 2 minutes, and then allowed to stand to separate into an octane phase (upper layer) and a DMF phase (lower layer). The upper octane phase was removed, and 8 mL of hexane was added thereto, and the mixture was stirred with a vortex mixer for 2 minutes. Again, the upper hexane phase was removed, and 8 mL of hexane was added thereto, followed by stirring with a vortex mixer for 2 minutes. The upper hexane phase was removed, 3.2 mL of toluene and 11.2 mL of hexane were added thereto, and the mixture was centrifuged. Then, the supernatant was removed, the precipitate was vacuum-dried for 15 minutes, and then re-dispersed in DMF to obtain a quantum dot dispersion liquid 2 (concentration: 50 mg/ml) in which MPA was coordinated to the InSb quantum dot as a ligand.

(Quantum Dot Dispersion Liquid 3)

9 mL of acetonitrile was added to 9 mL of the quantum dot dispersion liquid 1, and the mixture was centrifuged. Then, the supernatant was removed, and the precipitate was recovered. Octane was added to the recovered precipitate to obtain a quantum dot dispersion liquid 3a having a concentration of 9 mg/ml.

Separately, 1 g of indium iodide (InI3) and 0.09 g of ammonium acetate were dissolved in 20 mL of N,N-dimethylformamide (DMF) to produce an $InI_3$ ligand exchange solution 1.

6 mL of the $InI_3$ ligand exchange solution 1 and 4 mL of the quantum dot dispersion liquid 3a were added to a centrifuge tube, and the mixture was stirred with a vortex mixer for 2 minutes, and then allowed to stand to separate into an octane phase (upper layer) and a DMF phase (lower layer). The upper octane phase was removed, and 6 mL of octane was added thereto, and the mixture was stirred with a vortex mixer for 2 minutes. Again, the upper octane phase was removed, 6 mL of octane was added thereto, and the mixture was stirred with a vortex mixer for 2 minutes. The upper octane phase was removed, 12 mL of toluene was added thereto, the mixture was centrifuged, the supernatant was removed, the precipitate was vacuum-dried for 15 minutes, and then re-dispersed in DMF to obtain a quantum dot dispersion liquid 3 (concentration: 50 mg/ml) in which $InI_3$ was coordinated to the InSb quantum dot as a ligand.

(Quantum Dot Dispersion Liquid r1)

Acetonitrile was added to the quantum dot dispersion liquid 1, and the mixture was centrifuged. Then, the supernatant was removed, and the precipitate was recovered. Octane was added to the recovered precipitate to obtain a quantum dot dispersion liquid rla having a concentration of 50 mg/ml.

Separately, 23.4 mg of nitrosonium tetrafluoroborate ($NOBF_4$) was added to 10 mL of N,N-dimethylformamide (DMF), and the mixture was stirred to obtain a $NOBF_4$ solution.

10 mL of the $NOBF_4$ solution and 4 mL of the quantum dot dispersion liquid r1a were added to a centrifuge tube, and the mixture was stirred with a vortex mixer for 1 minute, and then allowed to stand to separate into an octane phase (upper layer) and a DMF phase (lower layer). The upper octane phase was removed, and 4 mL of hexane was added thereto, and the mixture was stirred with a vortex mixer for 1 minute. Again, the upper hexane phase was removed, and 4 mL of hexane was added thereto, followed by stirring with a vortex mixer for 2 minutes. The upper hexane phase was removed, 30 ml of toluene was added thereto, the mixture was centrifuged, the supernatant was removed, the precipitate was vacuum-dried for 1 day, and then re-dispersed in DMF to obtain a quantum dot dispersion liquid r1 (concentration: 50 mg/ml).

[Manufacture of Semiconductor Film]

(Example 1)

All of the following steps were performed in a nitrogen-filled glove box.

The quantum dot dispersion liquid 2 was added dropwise onto a gold-coated silicon substrate and spin-coated at

2,500 rpm to form an InSb quantum dot aggregate film (step 1).

Next, the $InI_3$ ligand exchange solution 2 prepared by adding 0.1 g of indium iodide to 20 mL of methanol and dissolving the indium iodide was added dropwise onto the InSb quantum dot aggregate film, and allowed to stand for 20 seconds and spin-dried at 2,500 rpm for 10 seconds (step 2).

Next, acetonitrile was added dropwise as a rinsing liquid onto the InSb quantum dot aggregate film, and spin drying was carried out at 2,500 rpm for 20 seconds (step 3).

Next, the mixture was heated at 120°C for 1 minute using a hot plate (step 4).

Steps 1 to 4 were repeated to form an InSb quantum dot aggregate film (semiconductor film) in which $InI_3$ and MPA were coordinated to the InSb quantum dot, with a thickness of 100 nm.

(Example 2)

An InSb quantum dot aggregate film (semiconductor film) in which methylammonium iodide (MAI) and MPA were coordinated to the InSb quantum dot was formed with a thickness of 100 nm by the same method as in Example 1, except that, in Example 1, an MAI ligand exchange solution prepared by dissolving 0.16 g of methylammonium iodide (MAI) in 50 mL of methanol was used instead of the $InI_3$ ligand exchange solution 2.

(Example 3)

An InSb quantum dot aggregate film (semiconductor film) in which $InI_3$ and MPA were coordinated to the InSb quantum dot was formed with a thickness of 100 nm by the same method as in Example 1, except that, in Example 1, the quantum dot dispersion liquid 3 was used instead of the quantum dot dispersion liquid 2, and an MPA ligand exchange solution obtained by mixing 20 $\mu$L of MPA with 50 ml of methanol was used instead of the $InI_3$ ligand exchange solution 2.

(Comparative Example 1)

An InSb quantum dot aggregate film (semiconductor film) in which sodium azide ($NaN_3$) and MPA were coordinated to the InSb quantum dot was formed with a thickness of 100 nm by the same method as in Example 1, except that, in Example 1, a $NaN_3$ ligand exchange solution prepared by dissolving 0.16 g of sodium azide ($NaN_3$) in 500 mL of methanol was used instead of the $InI_3$ ligand exchange solution 2.

(Comparative Example 2)

An InSb quantum dot aggregate film (semiconductor film) in which $InI_3$ and MPA were coordinated to the InSb quantum dot was formed with a thickness of 100 nm by the same method as in Example 1, except that, in Example 1, the quantum dot dispersion liquid r1 was used instead of the quantum dot dispersion liquid 2, and an $InI_3$-MPA ligand exchange solution obtained by mixing 0.05 g of $InI_3$ and 10 $\mu$L of MPA with 50 ml of methanol was used instead of the $InI_3$ ligand exchange solution 2.

[Measuring Method for Elemental Compositional Ratio of Semiconductor Film]

Using an X-ray photoelectron spectroscopy (XPS) apparatus, the elemental compositional ratio of the semiconductor film was measured by X-ray photoelectron spectroscopy under the following conditions. The molar ratio of the nitrogen element to the In element was recorded in the column of the N/In ratio in the following table, and the molar ratio of the nitrogen element to the halogen element was recorded in the column of the N/halogen ratio.

X-ray source: Monochromatized Al-K rays (100 mmf, 25 W, 15 kV)
Measurement region: 300 mm $\times$ 300 mm (Area measurement)
Pass Energy: 46.95 eV
Electrical charge correction: Yes (an electron gun and a low-speed ion gun are used in combination)
Photoelectron extraction angle: 45°

[Table 1]

| | N/In ratio | N/halogen ratio |
|---|---|---|
| Example 1 | 0.01 | 0.02 |

(continued)

| | N/In ratio | N/halogen ratio |
|---|---|---|
| Example 2 | 0.07 | 0.13 |
| Example 3 | 0.03 | 0.08 |
| Comparative Example 1 | 0.22 | - |
| Comparative Example 2 | 0 | 0 |

[Manufacturing of Photodetector]

[Examples 11 to 13 and Comparative Examples 11 and 12]

An indium tin oxide (ITO) film (the first electrode) having a thickness of about 100 nm was formed on quartz glass by a sputtering method.

Next, the first electrode was subjected to spin coating with a solution obtained by dissolving 1 g of zinc acetate dihydrate and 284 μL of ethanolamine in 10 mL of methoxyethanol at 3,000 rpm. Then, heating was carried out at 200°C for 30 minutes to form a zinc oxide film (electron transport layer) having a thickness of about 40 nm.

Next, a step of dropwise adding the above-described zinc oxide particle dispersion liquid onto the electron transport layer and subsequently carrying out spin coating at 2,500 rpm and heating at 70°C for 30 minutes was repeated twice to obtain a zinc oxide particle film having a film thickness of about 160 nm. After forming the zinc oxide particle film, an ultraviolet ozone treatment was carried out for 5 minutes under a condition of 30 $mW/cm^2$ (wavelength peak: 254 nm) using UVO-CLEANER MODEL 144AX-100 manufactured by Jelight Company Inc.

Next, the InSb quantum dot aggregate film (semiconductor film) was formed on the oxide zinc laminate with a thickness of 100 nm according to the methods of Examples 1 to 3 and Comparative Examples 1 and 2 to form a photoelectric conversion layer.

Next, a toluene solution (concentration: 10 mg/ml) of poly(3-hexylthiophene-2,5-diyl) (P3HT) was spin-coated on the photoelectric conversion layer at 2,000 rpm to form a hole transport layer.

Next, a $MoO_3$ film having a thickness of 10 nm was formed on the hole transport layer by a vacuum vapor deposition method through a metal mask, and then an Au film (the second electrode) having a thickness of 100 nm was formed to form three element parts, thereby manufacturing a photodiode-type photodetector.

[Performance Evaluation of Photodetector]

Regarding the produced photodetector, the dark current and external quantum efficiency (EQE) of the semiconductor film were evaluated by using a semiconductor parameter analyzer (C4156, manufactured by Agilent Technologies, Inc.).

First, the current-voltage characteristics (I-V characteristics) were measured while sweeping the voltage from 0 V to -2 V in a state of not carrying out irradiation with light, and the dark current was evaluated. Here, the current value at -2 V was defined as a dark current value. Subsequently, the I-V characteristics were measured while sweeping the voltage from 0 V to -2 V in a state of carrying out irradiation with monochromatic light (irradiation amount: 50 $\mu W/cm^2$) of 1,400 nm. A value obtained by subtracting the dark current value from the current value in a state where -2 V was applied was defined as the photocurrent value, and the external quantum efficiency (EQE) was calculated from the photocurrent value. It is noted that the numerical values described in the columns of the external quantum efficiency (EQE) and the dark current described in the table below are values of the central one element among the three element parts.

In addition, regarding the in-plane uniformity of the external quantum efficiency (EQE), the external quantum efficiency of each of the three element parts was measured, a value obtained by dividing a difference between the value of the highest external quantum efficiency and the value of the lowest external quantum efficiency by the external quantum efficiency of the element having the performance of the median value was calculated as ΔEQE, and the in-plane uniformity of the external quantum efficiency was evaluated based on ΔEQE. It means that the smaller the value of ΔEQE, the better the in-plane uniformity.

ΔEQE (%) = (value of highest external quantum efficiency - value of lowest external quantum efficiency)/median value of external quantum efficiency × 100

[Table 2]

| | Semiconductor Film | EQE (%) | Dark Current (A/cm$^2$) | ΔEQE |
|---|---|---|---|---|
| Example 11 | Example 1 | 7.5 | $2.3\times10^{-6}$ | 8.3 |
| Example 12 | Example 2 | 6.8 | $4.1\times10^{-6}$ | 9.7 |
| Example 13 | Example 3 | 7.3 | $2.4\times10^{-6}$ | 10.3 |
| Comparative Example 11 | Comparative Example 1 | <0.1 | $8.8\times10^{-7}$ | 125.6 |
| Comparative Example 12 | Comparative Example 2 | 2.9 | $7.1\times10^{-6}$ | 46.9 |

As described in the above table, the photodetectors of Examples had a higher external quantum efficiency (EQE) and better in-plane uniformity of the external quantum efficiency (EQE) than the photodetector of Comparative Examples. Further, the dark current was also low.

In a case of manufacturing an image sensor using the photodetector obtained in Examples by using an optical filter produced according to the method described in WO2016/186050A and WO2016/190162A and together with a publicly known method, it is possible to obtain an image sensor having good visibility and infrared imaging performance.

Explanation of References

1: photodetector
11: first electrode
12: second electrode
13: photoelectric conversion layer
21: electron transport layer
22: hole transport layer

## Claims

1. A semiconductor film comprising:

   an aggregate of semiconductor quantum dots containing an In element and a Group 15 element; and
   a ligand coordinated to the semiconductor quantum dots,
   wherein the Group 15 element includes an Sb element,
   the ligand includes a ligand containing a halogen element,
   the semiconductor film contains a nitrogen element, and
   a molar ratio of the nitrogen element to the In element is 0.01 to 0.10.

2. The semiconductor film according to claim 1,
   wherein a molar ratio of the nitrogen element to the halogen element in the semiconductor film is 0.01 to 0.20.

3. The semiconductor film according to claim 1,
   wherein a molar ratio of the nitrogen element to the halogen element in the semiconductor film is 0.01 to 0.10.

4. The semiconductor film according to any one of claims 1 to 3,
   wherein a molar ratio of the Sb element to the halogen element in the semiconductor film is 0.30 to 3.20.

5. The semiconductor film according to any one of claims 1 to 3,
   wherein the ligand containing the halogen element is a ligand containing an iodine element.

6. The semiconductor film according to any one of claims 1 to 3,
   wherein the ligand includes a ligand containing a sulfur element.

7. The semiconductor film according to any one of claims 1 to 3,
   wherein the ligand containing the halogen element contains an In element.

**8.** The semiconductor film according to any one of claims 1 to 3, wherein a band gap of the semiconductor quantum dots is 1.0 eV or less.

**9.** A photodetector comprising the semiconductor film according to any one of claims 1 to 3.

**10.** An image sensor comprising the photodetector according to claim 9.

FIG. 1

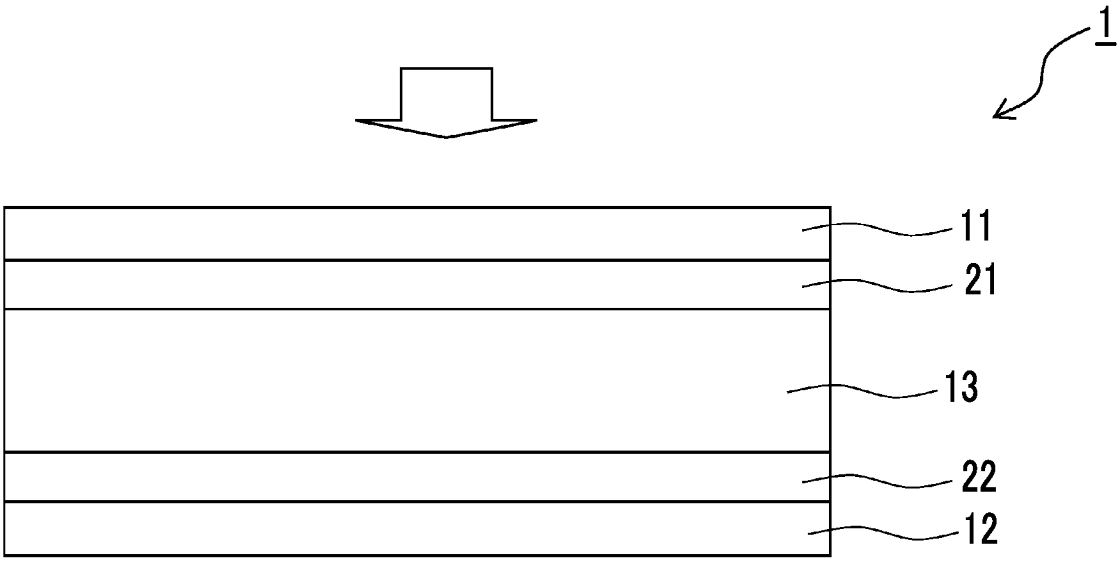

## INTERNATIONAL SEARCH REPORT

International application No.
**PCT/JP2024/029229**

**A. CLASSIFICATION OF SUBJECT MATTER**

***H01L 31/10***(2006.01)i; ***H01L 27/146***(2006.01)i; ***H10K 39/32***(2023.01)i
FI: H01L31/10 A; H01L27/146 C; H10K39/32

According to International Patent Classification (IPC) or to both national classification and IPC

**B. FIELDS SEARCHED**

Minimum documentation searched (classification system followed by classification symbols)

H01L31/00-31/119; H01L31/18-31/20; H10K30/00-99/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2018/163327 A1 (KAO CORPORATION) 13 September 2018 (2018-09-13) paragraphs [0002], [0007], [0017], [0019]-[0022], [0036]-[0038], [0040], [0044], [0047], [0051], [0114] | 1-10 |
| Y | WO 2022/244575 A1 (PANASONIC INTELLECTUAL PROPERTY MANAGEMENT CO., LTD.) 24 November 2022 (2022-11-24) paragraph [0051] | 1-10 |
| Y | JP 2023-117062 A (NIHON UNIVERSITY) 23 August 2023 (2023-08-23) paragraph [0023] | 1-10 |
| Y | WO 2021/206032 A1 (FUJIFILM CORPORATION) 14 October 2021 (2021-10-14) paragraphs [0026], [0029], [0045], [0067], [0091] | 6-7, 10 |
| A | US 2019/0385839 A1 (SAMSUNG ELECTRONICS CO., LTD.) 19 December 2019 (2019-12-19) entire text, all drawings | 1-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 September 2024** | **17 September 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**

International application No.
**PCT/JP2024/029229**

**C. DOCUMENTS CONSIDERED TO BE RELEVANT**

| Category* | Citation of document, with indication, where appropriate, of the relevant passages | Relevant to claim No. |
|---|---|---|
| A | US 2022/0290048 A1 (SAMSUNG ELECTRONICS CO., LTD.) 15 September 2022 (2022-09-15)<br>entire text, all drawings | 1-10 |

Form PCT/ISA/210 (second sheet) (July 2022)

**INTERNATIONAL SEARCH REPORT**
**Information on patent family members**

International application No.
**PCT/JP2024/029229**

| Patent document cited in search report | Publication date (day/month/year) | Patent family member(s) | Publication date (day/month/year) |
|---|---|---|---|
| WO 2018/163327 A1 | 13 September 2018 | US 2020/0075265 A1<br>paragraphs [0002], [0007], [0017], [0019]-[0022], [0036]-[0038], [0040], [0044], [0047], [0051], [0125]<br>CN 110383498 A<br>KR 10-2019-0126056 A | |
| WO 2022/244575 A1 | 24 November 2022 | US 2024/0049490 A1<br>paragraph [0059]<br>CN 117321781 A | |
| JP 2023-117062 A | 23 August 2023 | (Family: none) | |
| WO 2021/206032 A1 | 14 October 2021 | US 2023/0040906 A1<br>paragraphs [0048], [0051], [0072], [0097], [0120]<br>CN 115461878 A | |
| US 2019/0385839 A1 | 19 December 2019 | KR 10-2019-0141622 A | |
| US 2022/0290048 A1 | 15 September 2022 | KR 10-2022-0126528 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020150251 A
- US 11581501 B
- JP 2001291534 A
- JP 2013077009 A
- JP 2014130173 A
- JP 2014130338 A
- WO 2015166779 A
- WO 2016178346 A
- WO 2016190162 A
- WO 2018016232 A
- JP 2016177079 A
- JP 2014130332 A
- WO 2016027798 A
- WO 2016186050 A
- WO 2016035695 A
- JP 6248945 B
- WO 2019021767 A
- JP 2017067963 A
- JP 6506529 B
- JP 2014130344 A
- JP 2018010296 A
- WO 2019039172 A
- WO 2019017280 A
- WO 2018092600 A